(19) Europäisches Patentamt
European Patent Office
Office européen des brevets

(11) **EP 3 016 200 A1**

(12) **EUROPEAN PATENT APPLICATION**

(43) Date of publication:
**04.05.2016 Bulletin 2016/18**

(51) Int Cl.:
***H01Q 1/24*** *(2006.01)*

(21) Application number: **15152649.8**

(22) Date of filing: **27.01.2015**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **29.10.2014 US 201462072398 P
16.12.2014 US 201414572663**

(71) Applicant: **MediaTek Singapore Pte Ltd.
Singapore 138628 (SG)**

(72) Inventor: **Strange, Jonathan Richard
Reigate,, Surrey, RH2 9LA (GB)**

(74) Representative: **Wray, Antony John et al
Optimus Patents Limited
Grove House
Lutyens Close
Chineham Court
Basingstoke
Hampshire RG24 8AG (GB)**

(54) **Integrated circuit, wireless communication unit, and method for antenna matching**

(57)     A radio frequency integrated circuit (635) for a wireless device (500) to an antenna (502), wherein the antenna (502) is coupled to the radio frequency circuit (602) via at least one off-chip inductor (611, 613) that forms a first portion of an antenna matching circuit (530), wherein the integrated circuit (635) includes: a first port coupleable to the radio frequency integrated circuit (635); a second port coupleable to the antenna (502), and a second portion of the antenna matching circuit (530) located between the first port and second port and coupled in parallel with the at least one off-chip inductor (611, 613). The second portion of the antenna matching circuit (530) includes: at least one on-chip inductor (615, 617); and at least one radio frequency switch (606, 616) coupled in series with the at least one on-chip inductor (615, 617) and arranged to selectively introduce the at least one on-chip inductor (615, 617) into the antenna match-ing circuit (530).

FIG. 6

**Description**

The present invention relates to a radio frequency integrated circuit for antenna matching for a wireless communication unit and method therefor according to the pre-characterizing clauses of claims 1, 14 and 15.

As new generations of handsets, gateways, and other wireless communication devices become embedded with more applications, and the need for bandwidth becomes greater, new antenna systems will be required to optimise link quality. Specifically, better control of the radiated field will be required to provide better communication link quality with intended transceivers, whilst suppressing signals from undesired transceivers. Typically, during normal operation of a wireless communication device, impedance and/or frequency changes at the antenna create mismatches.

Antennas are transition devices (e.g. a form of transducer) that function between guided waves and free space waves. An antenna tuner (or Antenna Tuning Unit (ATU) as it is sometimes referred to) is a device that is connected between a radio transmitter and/or receiver and an antenna, and is used to improve power transfer between them by matching the impedance of the radio transmitter or receiver to the antenna. An antenna tuner matches a transceiver (radio transmitter and receiver) or a transmitter or a receiver with a fixed impedance (typically 50 ohms for modern transceivers) to a load (e.g. a feed line of an antenna) impedance that is unknown, complex or otherwise does not match the same output/input impedance of the radio transmitter and/or receiver. There are two forms of tuning in antennas: Antenna Frequency Tuning (AFT), and Antenna Impedance Tuning (AIT), which is the tuning executed by adjusting a feed point match to the antenna radiating element.

It is known that such impedance mismatches and/or frequency resonance mismatches have a significant impact on the power transfer through the antenna system. For example, such mismatches may occur if the antenna is repositioned near a reflective or (radio frequency) absorbent material, or if the antenna is positioned closer or further away from a head of a user. Maximising energy transfer through antenna systems is a key desirable performance criteria. Intelligent antenna systems to address such mismatches are therefore needed.

The theory for fixed frequency matching networks, including broadband matching networks, has been developed over many decades, with fundamental work summarized in *Microwave Filters, Impedance-Matching Networks, and Coupling Structures* by Matthaei, Young, and Jones.

The use of tuneable matching networks, however, is relatively new. Most tuneable matching networks are developed by modifying existing known fixed frequency matching networks by replacing fixed components with tuneable components. In practice, an antenna tuner is used to compensate for any antenna impedance change(s) due, say, to switching operating frequencies, which is exacerbated in small form factor devices such as mobile phones. Ideally, an antenna tuner also allows the use of one antenna to cover a broad range of frequencies. However, the range of frequencies covered by the antenna tuner is often restricted by the physical constraints of the lumped components or transmission line structure.

Furthermore, Long Term Evolution (LTE™) advanced network and carrier aggregation specifications are pushing radio frequency (RF) front-end performance demands higher. This often requires additional antennas or a multi-feed antenna to be added to, say, mobile communication handsets, which places further demands on antenna size or tuning selectivity. Hence, designing and manufacturing products that have tuneable devices has proved very popular in supporting the increased bandwidth demanded by LTE handsets, in particular by enabling small antennas that are efficient across the entire LTE bands, i.e. from 700MHz to 2.7GHz, although wider ranges for LTE are also possible e.g. 600MHz to 3.5GHz, etc. In many instances, the use of tuneable devices facilitates saving battery power and enables slim and thin handset designs.

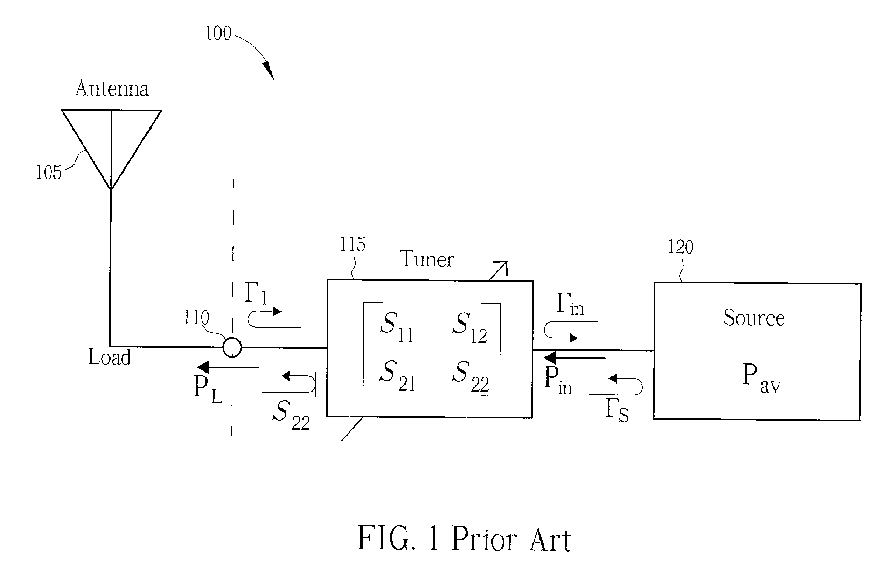

In mobile terminals (such as handsets) for wireless communications, use is increasingly being made of adaptive matching circuits for tuning the antenna, as illustrated in the known communication unit 100 of FIG. 1. Communication unit 100 comprises an antenna 105 coupled to an interface 110 that is coupled to a signal source 120 via a tuner 115. The tuner 115 is illustrated in an S-parameter form of a generic two port network, and thus is related to measurements of signals passing through the tuner as well as unmatched signals being reflected back into the tuner 115. Tuning circuits such as tuner 115 are intended to be used to ensure that the communication unit 100 always has optimum antenna matching. This is particularly helpful when the communication unit 100 is a mobile terminal operating in changing mobile environments that influence the impedance exhibited by the antenna 105. A coupler (not shown) extracts a portion of a transmitted signal and passes the signal to a controller to determine an amount of reflected power from the antenna 105 that is due to an impedance mismatch. The controller can then determine from such a measure of the impedance mismatch, how best to tune the tuner 115 in order to improve the matching and reduce reflected (and thereby wasted) power. This, in turn, improves the transmission (and reception) operation of the mobile terminal by saving transmission power and improving the reception quality.

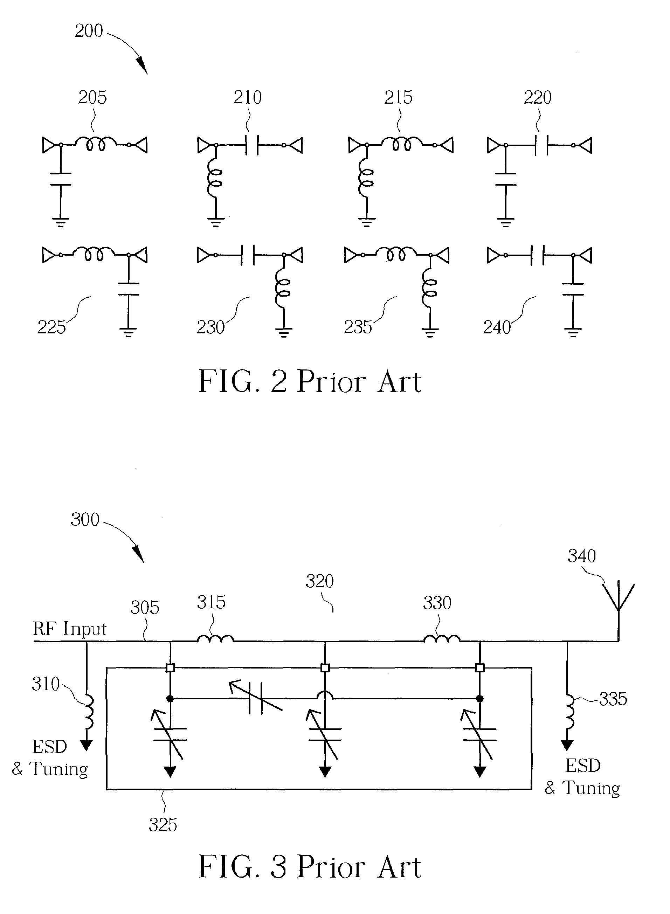

Impedance matching is generally used for fine radio frequency tuning over a limited tuning range. Impedance matching typically tunes the antenna element to the entire radio frequency or antenna system, thereby creating a tuned matching network that is added to the antenna input. Impedance matching is popular as it is easy to implement with inexpensive frequency selective components, such as inductors and capacitors, used in shunt or series configurations, as illustrated in FIG. 2. For example, FIG. 2 illustrates a range of narrow band fixed frequency 'L'-configuration options 200; such as a shunt capacitor followed by series inductor 205, a shunt inductor followed by series capacitor 210, a shunt inductor followed by series inductor 215, a shunt capacitor followed by series capacitor 220, series inductor followed by a shunt capacitor 225, a series capacitor followed by shunt inductor 230, a series inductor followed by shunt inductor 235, a series capacitor followed by shunt capacitor 240.

As a follow on from L-configurations, another form of impedance matching is known and uses ladder-type networks, generalized with tuneable elements, such as the impedance matching/tuning circuit 300 of FIG. 3. Impedance tuning circuit 300 comprises an input for receiving a radio frequency input signal 305 and an output coupled to an antenna 340. A main RF path 320 comprises an input shunt inductor 310 and an output shunt inductor 335 used predominantly for Electrostatic Discharge (ESD) as well as imparting some tuning effect. The main RF path 320 further comprises series inductors 315, 330, each coupled to a ladder network 325, comprising a number of varactors as shown. The varactors are tuned in order to adjust/match the impedance between the antenna 340 and a source of the RF input signal 305.

US 8,115,572 discloses such a ladder network with a bridge element that allows wide tuning range.

Another known form of impedance matching is to use tuneable elements that can either be capacitive imag($X_j$)<0, inductive imag ($X_j$) >0 or can transition from inductive to capacitive effects. For example this can be achieved through either series LC or parallel LC networks using a variable capacitor (varactor or digitally tunable capacitor).

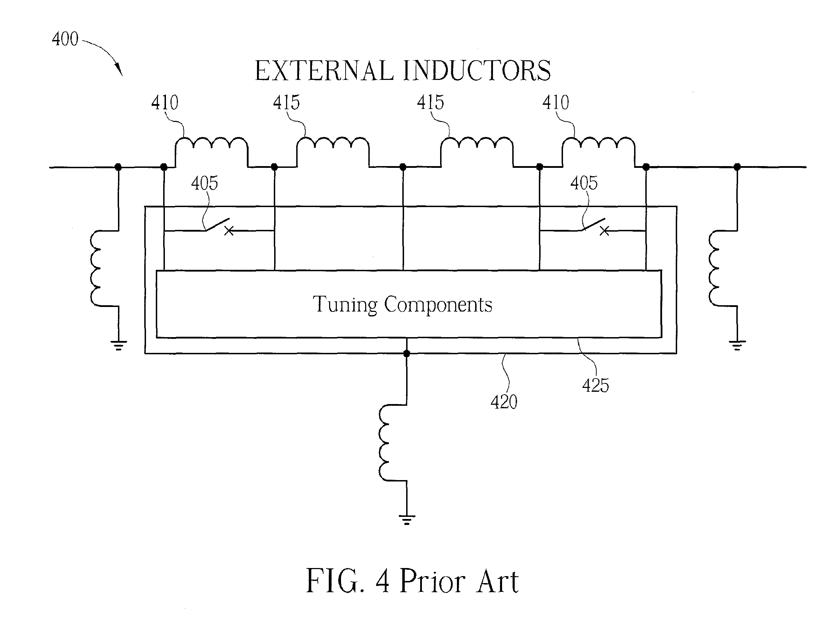

Of particular note is that most/all known antenna tuning schemes do not support inductors to be integrated on-chip without significant performance degradation, as illustrated in FIG. 4 and described in the paper titled "Advances in SOI Switched Capacitors for 4G Tunable Antennas", authored by J. Costa et al., and published at the IEEE conference IEEE IMS2014 in Florida 2014. FIG. 4 illustrates a known switchable inductor arrangement 400 for impedance matching to an antenna with the switchable inductors 410 being located off-chip, i.e. provided discretely and thus not located on a radio frequency integrated circuit (RFIC) 420. The on-chip switches 405 allow the radio frequency signals to bypass the switchable inductors 410, such that the radio frequency signals are affected by non-switchable inductors 415. In this RFIC 420, antenna tuning is supported using radio frequency tuning components 425. As mentioned in this paper, the low 'Q' of on-chip inductors limits their integration, although on-chip inductors also become less economically viable when their value is greater than a few nH in order to achieve an acceptable performance. A need exists for an improved antenna tuner circuit/arrangement (and a communication unit comprising such an antenna tuner) whereby the antenna tuner covers both a wide frequency range and covers a wide range of impedances. Furthermore, it would be advantageous to provide an improved antenna tuner circuit/arrangement that requires less cost and smaller component usage for present day wireless communication units.

This in mind, the present invention aims at providing a radio frequency integrated circuit for antenna matching for a wireless communication unit and method therefor.

This is achieved by a radio frequency integrated circuit and related wireless communication unit and method according to claims 1, 14 and 15. The dependent claims pertain to corresponding further developments and improvements.

Accordingly, the invention seeks to mitigate, alleviate or eliminate one or more of the above mentioned disadvantages, either singly or in any combination. Aspects of the invention provide a radio frequency integrated circuit comprising an antenna tuner arrangement, a wireless communication unit and a method therefor, as described in the appended claims.

These and other aspects of the invention will be apparent from, and elucidated with reference to, the embodiments described hereinafter.

Further details, aspects and embodiments of the invention will be described, by way of example only, with reference to the drawings. Elements in the figures are illustrated for simplicity and clarity and have not necessarily been drawn to scale. Like reference numerals have been included in the respective drawings to ease understanding.

In the following, the invention is further illustrated by way of example, taking reference to the accompanying drawings. Thereof

FIG. 1 illustrates a known impedance matching arrangement for an antenna,

FIG. 2 illustrates a known selection of impedance matching configurations for narrow band fixed frequency matching for an antenna,

FIG. 3 illustrates a known ladder network configuration for impedance matching to an antenna,

FIG. 4 illustrates a known switchable inductor arrangement for impedance matching to an antenna with the switchable inductors being located off-chip,

FIG. 5 illustrates an example block diagram of a wireless communication unit adapted to support impedance matching as part of antenna tuning,

FIG. 6 illustrates a further example block diagram of a part of an antenna tuner circuit and radio frequency integrated circuit therefor of a wireless communication unit, and

FIG. 7 illustrates one example flowchart of an operation of an antenna tuner circuit.

Examples of the invention herein described use the terms 'inductor' and 'capacitor'. However, these terms are described with reference to one example of a physical manifestation of any component that provides inductance and capacitance reactive properties; for example, a bond wire would be considered by a skilled person as being able to exhibit an inductance, but would not be referred to as an inductor, per se. As such, the use of the terms 'inductor' and 'capacitor' in the description and claims encompasses any such component or circuit that provides these associated reactive properties.

A high quality (Q) factor in radio frequency components (such as both capacitors and inductors) is a desirable feature of any matching network since it minimises losses. For tunable radio frequency circuits, a wide tuning range is also needed and there is a direct trade-off often between the tuning range and 'Q'. The inventors of the present invention have recognised and appreciated that designing a radio frequency circuit to provide a very high 'Q' is not critically important, and, in some instances, it may be more appropriate to keep the loss at an acceptable level to allow some flexibility to partially integrate some radio frequency components, particularly inductors.

Therefore, some examples of the invention describe an antenna tuning network, for example for an antenna impedance matching circuit in a wireless communication unit, that is capable of supporting a wide tuning range of inductive elements whilst maintaining an acceptable quality factor of the tuning network. A total loss of the tunable matching network is the sum of dissipative losses and mis-match losses. Mis-match losses are minimized by having a wide tuning range tunable component but this is at the expense of component Q and hence increases dissipative losses. Therefore, examples herein described provide a good tunable matching topology that balances these dissipative and mis-match losses. In particular, a tuning network topology is described that facilitates at least a partial integration of inductors on-chip. In some examples, the tuning inductor components are arranged such that one inductor is off-chip and one switchable inductor is located on-chip, together with a suitable switch.

Although examples of the invention are described with reference to an impedance matching network using switchable inductors in a double-PI network, it is envisaged that other examples may employ a single PI network. It is also envisaged that in other examples, multiple concatenated PI networks (e.g. a triple-PI network) or multiple concatenated double-PI networks may be employed. It is also envisaged that in other examples, the on-chip switched inductor techniques may be applied to 'T'-based networks. It is also envisaged that in other examples, the on-chip switched inductor techniques may be applied to other frequency-dependent circuits and not necessarily limited to impedance matching and antenna tuning. It is also envisaged that in other examples, the switchable inductors may be used in either or both or all series inductive elements and shunt inductive elements.

Examples of the invention may be applicable to, but not limited to, a circuit design for an antenna tuner, for example as an impedance matching circuit, that facilitates some of the inductive elements of the circuit being implemented on-chip, thereby reducing cost and size when implementing antenna tuning for current mobile/portable wireless communication unit products.

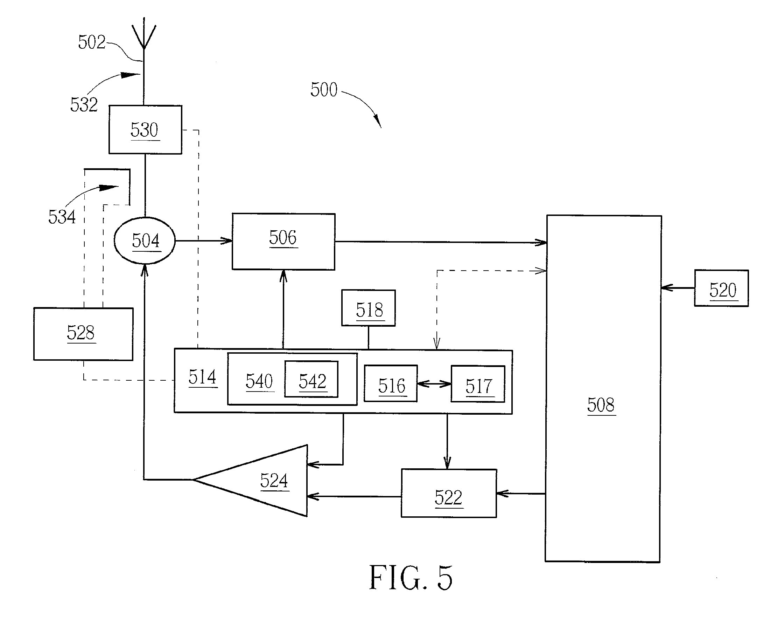

Referring now to FIG. 5, a block diagram of a wireless communication unit 500, adapted in accordance with some example embodiments of the invention, is shown. In practice, purely for the purposes of explaining embodiments of the invention, the wireless communication unit is described in terms of a wireless subscriber communication unit, which in some examples may be a smartphone.

The wireless communication unit 500 contains an antenna arrangement 502, for radiating signals and/or for receiving transmissions, coupled to an antenna switch or duplexer 504 that provides isolation between receive and transmit chains within the wireless communication unit 500. In this example, the coupling of the antenna arrangement 502 with antenna switch or duplexer 504 is made via an impedance matching circuit 530.

One or more receiver chains, as known in the art, include receiver front-end circuitry 506 (effectively providing reception, filtering and intermediate or base-band frequency conversion). The receiver front-end circuitry 506 is coupled to a signal processing module 508 (generally realized by a Digital Signal Processor (DSP)). A skilled artisan will appreciate that the level of integration of receiver circuits or components may be, in some instances, implementation-dependent.

A controller 514 maintains overall operational control of the wireless communication unit 500. The controller 514 is coupled to the receiver front-end circuitry 506 and the signal processing module 508. In some examples, the controller 514 is also coupled to a buffer module 517 and a memory device 516 that selectively stores operating regimes, such as antenna tuning information, and the like. A timer 518 is operably coupled to the controller 514 to control the timing of operations (e.g. transmission or reception of time-dependent signals) within the wireless communication unit 500.

The transmit chain includes transmitter/modulation circuitry 522 and a power amplifier 524 coupled to the antenna arrangement 502, which may comprise for example an antenna array, or plurality of antennas. The transmitter/modulation circuitry 522 and the power amplifier 524 are operationally responsive to the controller 514. In some examples, the signal processing module 508 and/or controller 524 may receive inputs from one or more input device or sensor modules 520.

A Radio Frequency (RF) measurement module or circuit 528 may be operably coupled to antenna tuning processing module 540, which may be located in, or associated with, controller 514. In this example RF measurement module or circuit 528 is connected to a directional coupler 534 that is located between impedance matching circuit 530 and antenna switch or duplexer 504. In some examples, RF measurement module or circuit 528 may measure one or more parameters, for example representative of a signal passing through the impedance matching circuit 530 or indicative of a performance of the impedance matching circuit 530. In some examples, the RF measurement module or circuit 528 may provide this measurement information to controller 514, or antenna tuning processing module 540 that may comprise an algorithm 542 operable to perform an antenna impedance matching procedure in response thereto. In some examples, therefore, algorithm 542 may employ an impedance matching/antenna tuning procedure that is instigated in response to a determined impedance mismatch and results in adjusting one or more components of impedance matching circuit 530 to adjust a perceived impedance thereof.

In other examples, the directional coupler 534 may be directly coupled to a second port of the antenna input 532 (sometimes referred to as feed point). In some examples, the measured parameter may comprise at least one of: antenna input complex impedance value, antenna input complex reflection coefficient or reflection coefficient magnitude, related to signals passing through directional coupler 534 to the antenna arrangement 502 via impedance matching circuit 530.

In some examples in, say, a multi-band Third Generation (3G) or Fourth Generation (4G) radio platform, such an antenna tuning approach may be implemented at the main and diversity and/or Multiple Input-Multiple Output (MIMO) antennas. Clearly, a number of the various components within the wireless communication unit 500 can be realized in discrete or integrated component form, with an ultimate structure therefore being application-specific or design-based.

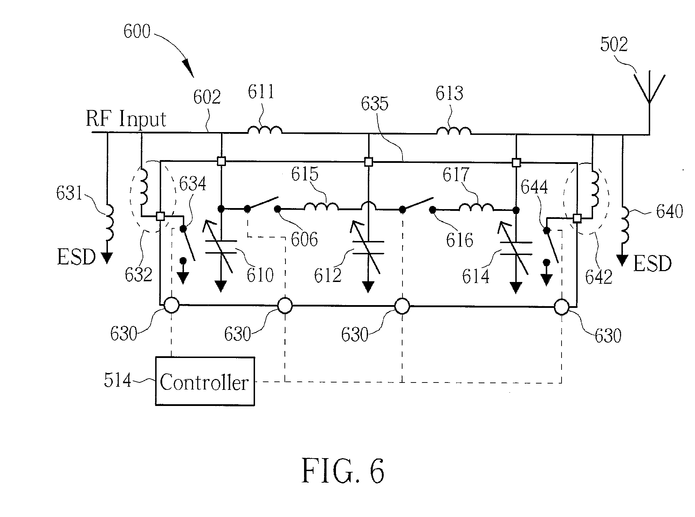

Referring now to FIG. 6 a further example of a part of an antenna tuner circuit 600 of a wireless communication unit, and radio frequency integrated circuit therefor, is illustrated. In this example, a portion of the impedance matching circuit 530 of FIG. 5 is in a form of an integrated circuit 635. The example circuit diagram 600 is arranged to support a wide frequency range, e.g. 700-2700MHz and this example is again illustrated with, but not limited to, a double PI design. The example antenna tuner circuit 600 is further arranged to use a number of low cost components and distribute the component values in order to reduce cost, reduce size, improve the quality ('Q') factor of the circuit, support the aforementioned wide frequency range and reduce the impact on Relative Transducer Gain (RTG), where:

$$RTG = \frac{\text{Incident power to antenna with a tuner}}{\text{Incident power to antenna without a tuner}} \quad [1]$$

The further example antenna tuner circuit 600 comprises an RF input 602 that is operably coupled to an antenna 502 via two fixed inductors 611, 613, arranged in series. In this example, the input to the antenna tuner circuit 600 also optionally comprises a first electrostatic discharge shunt inductor 631 and a second switchable shunt inductor 632 operably coupleable to ground via first switch 634. Similarly, the output to the antenna tuner circuit 600 comprises a third electro static discharge shunt inductor 640 and a fourth switchable shunt inductor 642 operably coupleable to ground via second switch 644. As illustrated, the first switch 634 and second switch 644 are operably coupleable to, and their respective function controlled by, a controller, such as controller 514 from FIG. 5.

In some examples, the integrated circuit 635 further comprises at least one controller port 630 operably coupling the controller 514 to the at least one radio frequency switch 606, 616 and arranged to provide one or more selective control signal (s) thereto. Thus, in some examples, one or more switchable inductors located on the integrated circuit 635 may be incorporated into the RF circuit in response to one or more selective control signal(s) being independently applied to more than one radio frequency switch 606, 616. In some examples, further ports on the integrated circuit 635 may be coupled to the controller 514 and arranged to selectively switch into the circuit one or more shunt inductors, such as switchable shunt inductor 642 operably coupleable to ground via second switch 644.

As illustrated, the two inductors 611, 613 in series form a first and second PI network of the antenna tuner circuit, with a first PI network comprising first variable capacitor 610 and second variable capacitor 612 coupling either side of first inductor 611 to ground, and second PI network comprising second variable capacitor 612 and third variable capacitor 614 coupling either side of second inductor 613 to ground.

Examples of the invention may be configured to provide (a) a wide tuning range of inductive elements, and/or (b) maintaining quality factor of the network to reduce dissipative losses in the network. Thus, the varactors 610, 612, 614 may be tuned, as well as switchable fixed inductors 615, 617 switched into/out of the circuit, in order to adjust/match the impedance between the antenna 502 and a source of the RF input signal 602.

Thus, in this example, the inductance value provided by respective first and second PI networks is arranged to be configurable with a selective introduction of switchable inductors located in parallel with respective inductors 611, 613. For example, first switch 606 is arranged to couple first switchable inductor 615 into the main signal path in conjunction with first inductor 611. Thus, when the first switch 606 is arranged to be open, the total inductance provided in the first PI network is due solely to the first inductor 611. In contrast, when the first switch 606 is arranged to be closed, the total inductance (Lt) provided in the first PI network is configured to be:

$$Lt = L1*L2 / (L1+L2) \qquad\qquad [2]$$

Where:

L1 is the value of the first inductor 611; and
L2 is the value of the first switchable inductor 615.

Similarly, second switch 616 is arranged to couple second switchable inductor 617 into the main signal path in conjunction with second inductor 613. Thus, when the second switch 616 is arranged to be open, the total inductance provided in the second PI network is due solely to the second inductor 613. In contrast, when the second switch 616 is arranged to be closed, the total inductance provided in the second PI network is configured to be [2], with L1 being the value of the second inductor 613; and L2 being the value of the second switchable inductor 617.

Notably, in accordance with examples of the invention, the switchable inductors 615, 617 may be implemented as on-chip. The switchable inductors 615, 617 may be provided with as high a 'Q' value as possible, albeit that there is no need to have as high a 'Q' value as is typical with off-chip inductors due to the 'Q' value limitations inherently imposed by the RF switch. For example, an off-chip inductor would typically achieve a 'Q' value of 120 at 2GHz, whereas an on-chip inductor would typically achieve a 'Q' value of 20 at 2GHz. The inventors have recognised and appreciated that an on-chip L2 inductor having a 'Q' value of 20 at 2GHz is acceptable.

In some examples, an increased operational bandwidth of a communication unit may be supported by selective introduction of the switchable inductors 615, 617. For example, if a tuning range of 0.7-2.7GHz is required to be supported, a total inductance ratio of approximately 5:1 may be used. In this example, therefore, an inductance value ratio, when switching first and second switchable inductors into the main signal path, may be approximately: L1 / L2 ~ 3 (e.g. if L1=1 and L2=3; From [2] Lt = L1*L2/(L1+L2) = 0.75 and Lt from [2] is 3/0.75 = 5).

It is known that an inductor 'Q' value decreases with frequency. Hence, in order to achieve a as high 'Q' value as possible for a total inductance of [2] when first switch 606 and second switch 616 are closed, particularly at low frequencies it is beneficial if the combination of L1 and L2 provide a high 'Q' value inductance. However, the 'Q' value is limited to the presence of the configurable switches. In contrast, when first switch 606 and second switch 616 are configured as open, then L2 is not a part of the active circuit and, hence, is not needed to be a high-Q value. Thus, when the configurable switches are closed, the Q value of L2 does not need to be high due to the present of the configurable switch, and when configurable switches are open, the Q value of L2 does not need to be high as it is not part of the active circuit. Here, the 'Q' value of L1 is the determining 'Q' factor. Thus, and advantageously, L2 may be implemented on-chip and as a low 'Q', as the 'Q' value of the switch(es) constitute the major influence on the circuit 'Q' performance.

In some examples, first switch 606 and second switch 616 may be implemented as RF switches, which in some examples may typically be implemented as silicon on insulator (SOI) and where the on resistance (Ron) may be typically of the order of 1Ω for a reasonable size and performance. For example, for a small value inductor 0.5-2nH @ ~2GHz operation it may be possible to achieve a Q ~ 20 for an on-chip planar L2 inductor, where L2 has, say, an effective series resistance, Rs=0.95Ω. Thus, in most practical examples for present-day wireless mobile communications, an inductor value for the on-chip planar L2 inductor of <4nH may be used.

With regard to Q factor of the inductors being used, both on-chip and off-chip, then it is noted that Q is frequency dependent. Consequently, in most practical scenarios, to achieve a reasonable Q factor at the antenna operating frequency, then a ratio of Q factors for the respective inductors may be substantially of the order of: Q(L1)/Q(L2) >= 2:1.

In some examples, the input reflection coefficient may be controlled to be a low value versus the antenna reflection coefficient and phase angle with a suitable and careful selection of a total inductance and/or capacitance value with a suitable opening or closing of at least one radio frequency switch. In this manner, a tuneable ladder network may be configured. In some examples, the tuneable ladder network may be a multiple-pi based architecture, e.g. a double pi-based architecture, with switchable inductors. In some examples, the tuneable ladder network may be a multiple-T based architecture, e.g. a double T-based architecture, with switchable inductors. In some examples, the tuneable ladder network may be supplemented with optional shunt inductors connected to the main RF signal path. In some examples, the switchable inductors may be used in either the series or shunt elements.

In some examples, the varactors 610, 612, 614 may be tuneable capacitors implemented with Silicon on Insulator (SOI). In some examples, the varactors 610, 612, 614 may be of the form of Digitally Controllable Capacitors (DCAPs), RF Microelectromechanical System (MEMs) capacitors, Barium Strontium Titanate (BST) capacitors, etc. RF MEMs capacitors are electronic components of which moving sub-millimeter-sized parts provide RF functionality. BST capacitors may be manufactured on silicon or ceramic wafers and offer high capacitance density, high frequency performance, and the ability to provide exceptional tenability for voltage tuneable high frequency applications.

Notably, in example embodiments herein described, inductors 615, 617 are implemented using fixed inductors and switches, for example to facilitate switching a total inductance value between two values that are deemed most practical for the particular application. In some examples, an input shunt inductor and an output shunt inductor (not shown) may also be used, predominantly for electronic discharge protection.

Thus, the hereinbefore examples provide a radio frequency integrated circuit and a wireless communication unit providing improved antenna tuning.

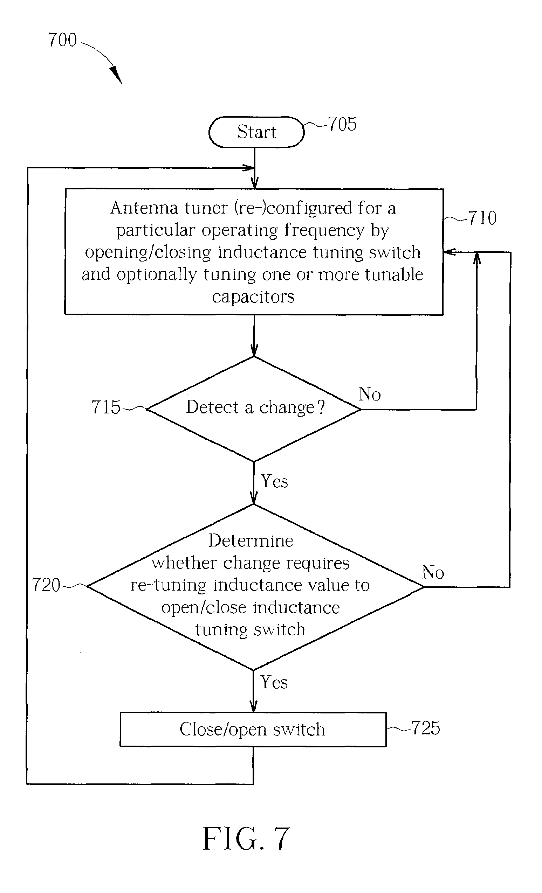

FIG. 7 illustrates one example flowchart 700 of an operation of an antenna tuning operation. The flowchart 700 describes one example of a method of antenna matching in a wireless communication unit that comprises: a radio frequency circuit; a controller; an antenna; and an antenna matching circuit. The antenna matching circuit is located between the radio frequency circuit and the antenna, and comprises a first portion comprised of at least one first frequency-dependent discrete component; and a second portion located within a radio frequency integrated circuit and operably coupled to the first portion. The method comprises: determining a change in an operating frequency of the wireless communication unit; and in response thereto, applying a control signal to at least one radio frequency switch located within the radio frequency integrated circuit; and in response thereto selectively introducing on-chip inductor coupled in series with the radio frequency switch and located in the radio frequency integrated circuit into the antenna matching circuit.

In particular, the flowchart 700 commences at 705 with an antenna tuner of a wireless communication unit being configured for a particular operating frequency at 710. In one example, the operating frequency may be selected by opening or closing at least one radio frequency switch arranged to switch radio frequency signals into a transmit or a receive path via, say, at least one (further) inductor and in most cases tuning one or more tunable capacitors. If a change in the operating frequency is not detected at 715, the process loops back to 710. If a change in the operating frequency is detected in 715, the process moves to 720, where a determination is made as to whether (or not) the change requires a re-tuning operation to introduce a new/modified inductance value through opening or closing the radio frequency switch. If the determination in 720 is that the change does not require a re-tuning operation, the process loops back to 710. If the determination in 725 is that the change does require a re-tuning operation, the process moves to 725, where the at least one radio frequency switch is closed (if already opened) or opened (if already closed), thereby changing the total inductance value and therefore the impedance match at the particular operating frequency. The flowchart then loops back to 710 and continues to loop as described until a frequency change is detected at 715. In other examples, a re-tuning operation may be effected due to other changes, such as a change in the physical/spatial location of the antenna.

Advantageously, for example in response to a control signal that opens or closes one or more of the tuneable switches, some of the example embodiments of the invention may provide a wide tuning range of inductive elements whilst maintaining a quality factor of the network to reduce dissipative losses in the network. In contrast to normal practice, where a provision of a high Q over a wide tuning/frequency range requires a use of off-chip inductors as on-chip inductors cannot achieve high Q, the topology according to example embodiments allows partial integration of inductive elements, e.g. one (or more) on-chip inductive element (s) and one or more off chip inductive element (s) are used. By use of inductor switching, a desired total inductance value may be achieved using one or more integrated on-chip inductors whilst still achieving an acceptable performance across a wide operating bandwidth. In this manner, cost is significantly reduced as integrated inductors are much less expensive.

Furthermore, and advantageously in response to a control signal that opens or closes one or more of the tuneable switches, example embodiments of the invention may provide a reduced size of a matching/tuning circuit to achieve similar performance to known circuits, as a number of inductive elements may be implemented (integrated) on-chip, as measured by the RTG.

It is envisaged that the aforementioned inventive concept can be applied by a semiconductor manufacturer to any integrated circuit comprising a switchable inductive network whereby at least one inductor may be implemented/integrated on-chip. It is further envisaged that, for example, a semiconductor manufacturer may employ the inventive concept in a design of a stand-alone device, such as a radio frequency application-specific integrated circuit (ASIC) and/or any other sub-system element.

It will be appreciated that, for clarity purposes, any suitable distribution of functionality between different functional units or components may be used, for example with respect to the implementation/integration on-chip of a switchable inductive or capacitive network, without detracting from the invention. Hence, references to specific functional units are only to be seen as references to suitable means for providing the described functionality, rather than indicative of a strict logical or physical structure or organization.

Aspects of the invention may be implemented in any suitable form including hardware, software, firmware or any combination of these. Some example aspects of the invention, such as tuning algorithms, may optionally be implemented, at least partly, as computer software running on one or more data processors and/or digital signal processors or configurable module components such as Field Programmable Gate Array (FPGA) devices. Thus, the elements and components of an embodiment of the invention may be physically, functionally and logically implemented in any suitable way. Indeed, the functionality may be implemented in a single unit, in a plurality of units or as part of other functional units.

Although the present invention has been described in connection with some embodiments, it is not intended to be limited to the specific form set forth herein. Rather, the scope of the present invention is limited only by the accompanying claims. Additionally, although a feature may appear to be described in connection with particular embodiments, one skilled in the art would recognize that various features of the described embodiments may be combined in accordance with the invention. In the claims, the term 'comprising' does not exclude the presence of other elements or steps.

Furthermore, although individually listed, a plurality of means, elements or method steps may be implemented by, for example, a controller or processor. Additionally, although individual features may be included in different claims, these may possibly be advantageously combined, and the inclusion in different claims does not imply that a combination of features is not feasible and/or advantageous. Also, the inclusion of a feature in one category of claims does not imply a limitation to this category, but rather indicates that the feature is equally applicable to other claim categories, as appropriate.

Furthermore, the order of features in the claims does not imply any specific order in which the features must be performed and in particular the order of individual steps in a method claim does not imply that the steps must be performed in this order. Rather, the steps may be performed in any suitable order. In addition, singular references do not exclude a plurality. Thus, references to 'a', 'an', 'first', 'second', etc. do not preclude a plurality.

Thus, a radio frequency integrated circuit for a wireless device comprising a radio frequency circuit coupled to an antenna via at least one off-chip inductor that forms a first portion of an antenna matching circuit is described. The radio frequency integrated circuit comprises: a first port coupleable to the radio frequency circuit, and a second port coupleable to the antenna; and a second portion of the antenna matching circuit located between the first port and second port and coupled in parallel with the at least one off-chip inductor. The second portion of the antenna matching circuit comprises: at least one on-chip inductor; and at least one radio frequency switch coupled in series with the at least one on-chip inductor and arranged to selectively introduce the at least one on-chip inductor into the antenna matching circuit. In this manner, an improved radio frequency integrated circuit for an antenna circuit has been described, wherein the aforementioned disadvantages with prior art arrangements have been substantially alleviated.

**Claims**

1. A radio frequency integrated circuit (635) for a wireless device (500) comprising a radio frequency circuit (602) coupled to an antenna (502) via at least one off-chip inductor (611, 613) that forms a first portion of an antenna matching circuit (530), the radio frequency integrated circuit (635) **characterized by**:

   a first port coupleable to the radio frequency circuit (602), and a second port coupleable to the antenna (502); and
   a second portion of the antenna matching circuit (530) located between the first port and second port and coupled in parallel with the at least one off-chip inductor (611, 613) and comprising:

   at least one on-chip inductor (615, 617); and
   at least one radio frequency switch (606, 616) coupled in series with the at least one on-chip inductor (615, 617) and arranged to selectively introduce the at least one on-chip inductor (615, 617) into the antenna matching circuit (530).

2. The radio frequency integrated circuit (635) of Claim 1 **characterized in that** the at least one radio frequency switch (606, 616) is arranged to selectively remove the at least one on-chip inductor (615, 617) from the antenna matching circuit (530) that comprises the at least one off-chip inductor (611, 613).

3. The radio frequency integrated circuit (635) of Claim 1 **characterized in that** the at least one on-chip inductor (615, 617) has an inductance value in a range of a half to a tenth of an inductance value of the at least one off-chip inductor (611, 613) .

4. The radio frequency integrated circuit (635) of Claim 3 **characterized in that** the at least one on-chip inductor (615, 617) has an inductance value substantially of a third of the inductance value of the at least one off-chip inductor (611, 613).

5. The radio frequency integrated circuit (635) of Claim 1 **characterized in that** the at least one on-chip inductor (615, 617) is a switched series inductor.

6. The radio frequency integrated circuit (635) of Claim 1 **characterized in that** the at least one on-chip inductor (615, 617) forms a part of the second portion of a PI antenna matching circuit (530).

7. The radio frequency integrated circuit (635) of Claim 6 **characterized in that** the at least one on-chip inductor (615, 617) forms a part of the second portion of a multiple-PI antenna matching circuit (530).

8. The radio frequency integrated circuit (635) of Claim 7 **characterized in that** the multiple-PI antenna matching circuit (530) is a double PI matching circuit.

9. The radio frequency integrated circuit of Claim 1 **characterized in that** the at least one on-chip inductor (615, 617) forms a part of the second portion of a T antenna matching circuit (530).

10. The radio frequency integrated circuit (635) of Claim 9 **characterized in that** the at least one on-chip inductor (615, 617) forms a part of the second portion of a multiple-T antenna matching circuit (530).

11. The radio frequency integrated circuit (635) of Claim 10 **characterized in that** the multiple-T antenna matching circuit (530) is a double-T matching circuit.

12. The radio frequency integrated circuit (635) of Claim 1 **characterized in that** the radio frequency integrated circuit (635) further comprises at least one further switch (634, 644) operably coupleable to at least one shunt inductor (632, 642) coupled to at least one of: the first port, the second port.

13. The radio frequency integrated circuit (635) of Claim 1 **characterized in that** the radio frequency integrated circuit (635) further comprises at least one third port (630) operably coupled to the at least one radio frequency switch (606, 616) and arranged to provide a selective control signal thereto.

14. A wireless communication unit (500) **characterized by**:

    a radio frequency circuit (602);
    an antenna (502);
    a controller (514); and
    an antenna matching circuit (530), located between the radio frequency circuit (602) and the antenna (502), and comprising:

       a first portion comprised of at least one off-chip inductor (611, 613); and
       a second portion, located within a radio frequency integrated circuit (635), and coupled in parallel with the at least one off-chip inductor (611, 613), and comprising:

          at least one on-chip inductor (615, 617); and
          at least one radio frequency switch (606, 616) coupled in series with the at least one on-chip inductor (615, 617) and arranged to receive a control signal from the controller (514) and in response thereto selectively introduce the at least one on-chip inductor (615, 617) into the antenna matching circuit (530).

15. A method of antenna matching in a wireless communication unit (500) comprising: a radio frequency circuit (602); a controller (514); an antenna (502); and an antenna matching circuit (530), located between the radio frequency circuit (602) and the antenna (502), and comprising a first portion comprised of at least one off-chip inductor (611, 613); and a second portion located within a radio frequency integrated circuit (635) coupled in parallel with the at least one off-chip inductor (611, 613), the method **characterized by**:

    determining a change in an operating frequency of the wireless communication unit (500); and in response thereto:

       applying a control signal to at least one radio frequency switch (606, 616) located within the radio frequency integrated circuit (635); and in response thereto
       selectively introducing at least one on-chip inductor (615, 617) coupled in series with the radio frequency switch (606, 616) and located in the radio frequency integrated circuit (635) into the antenna matching circuit (530).

FIG. 1 Prior Art

FIG. 2 Prior Art

FIG. 3 Prior Art

EP 3 016 200 A1

EXTERNAL INDUCTORS

Tuning Components

FIG. 4 Prior Art

FIG. 5

FIG. 6

EP 3 016 200 A1

700

Start ~705

Antenna tuner (re-)configured for a
particular operating frequency by
opening/closing inductance tuning switch
and optionally tuning one or more tunable
capacitors

~710

715 — Detect a change? No

Yes

720 — Determine
whether change requires
re-tuning inductance value to
open/close inductance
tuning switch

No

Yes

Close/open switch ~725

FIG. 7

Europäisches Patentamt

European Patent Office

Office européen des brevets

# EUROPEAN SEARCH REPORT

Application Number

EP 15 15 2649

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2012/249270 A1 (LI JING [US] ET AL) 4 October 2012 (2012-10-04) * figure 2a * * paragraphs [0025] - [0027] * | 1-5,14, 15 | INV. H01Q1/24 |
| X | US 2013/034088 A1 (JOSHI ALOK PRAKASH [IN] ET AL) 7 February 2013 (2013-02-07) * abstract; figure 3c * * paragraph [0042] * | 1,3,4, 10,11, 13-15 | |
| X | EP 1 605 589 A1 (NTT DOCOMO INC [JP]) 14 December 2005 (2005-12-14) * abstract; figures 38-42 * * paragraphs [0086] - [0089] * | 1,3,4, 10-15 | |
| X | MARC J FRANCO ET AL: "Broadband reconfigurable matching network of reduced dimensions for the UHF military satellite communication band", MICROWAVE SYMPOSIUM DIGEST (MTT), 2011 IEEE MTT-S INTERNATIONAL, IEEE, 5 June 2011 (2011-06-05), pages 1-4, XP032006633, DOI: 10.1109/MWSYM.2011.5972685 ISBN: 978-1-61284-754-2 * figures 1,2 * * pages 1,2 * | 1,3,4, 6-9,14, 15 | TECHNICAL FIELDS SEARCHED (IPC) H01Q |
| A | US 2013/063223 A1 (SEE PUAY HOE [US] ET AL) 14 March 2013 (2013-03-14) * abstract; figures 5a-5f,8a-8t * * paragraphs [0064] - [0084] * | 1-15 | |
| A | US 2009/085818 A1 (ROHANI NADER [US] ET AL) 2 April 2009 (2009-04-02) * abstract; figures 2,4 * * paragraphs [0011], [0012] * | 1-15 | |

The present search report has been drawn up for all claims

| Place of search | Date of completion of the search | Examiner |
|---|---|---|
| Munich | 9 March 2016 | Unterberger, Michael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 15 15 2649

This annex lists the patent family members relating to the patent documents cited in the above-mentioned European search report.
The members are as contained in the European Patent Office EDP file on
The European Patent Office is in no way liable for these particulars which are merely given for the purpose of information.

09-03-2016

| Patent document cited in search report | | | Publication date | Patent family member(s) | | | Publication date |
|---|---|---|---|---|---|---|---|
| US 2012249270 | A1 | | 04-10-2012 | US<br>US | 2012249270<br>2014342681 | A1<br>A1 | 04-10-2012<br>20-11-2014 |
| US 2013034088 | A1 | | 07-02-2013 | NONE | | | |
| EP 1605589 | A1 | | 14-12-2005 | CN<br>EP<br>JP<br>US<br>WO | 1762097<br>1605589<br>4464919<br>2007018758<br>2004082138 | A<br>A1<br>B2<br>A1<br>A1 | 19-04-2006<br>14-12-2005<br>19-05-2010<br>25-01-2007<br>23-09-2004 |
| US 2013063223 | A1 | | 14-03-2013 | CN<br>EP<br>JP<br>KR<br>US<br>WO | 103797708<br>2756597<br>2014530543<br>20140060577<br>2013063223<br>2013040272 | A<br>A2<br>A<br>A<br>A1<br>A2 | 14-05-2014<br>23-07-2014<br>17-11-2014<br>20-05-2014<br>14-03-2013<br>21-03-2013 |
| US 2009085818 | A1 | | 02-04-2009 | NONE | | | |

EPO FORM P0459

For more details about this annex : see Official Journal of the European Patent Office, No. 12/82

**EP 3 016 200 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8115572 B

**Non-patent literature cited in the description**

- **J. COSTA et al.** Advances in SOI Switched Capacitors for 4G Tunable Antennas. *IEEE conference IEEE IMS2014,* 2014